# EUROPÄISCHE PATENTSCHRIFT

(11) **EP 0 460 561 B1**
(45) Veröffentlichungstag und Bekanntmachung des Hinweises auf die Patenterteilung: **13.05.1998**
(21) Anmeldenummer: 91109008.2
(22) Anmeldetag: 03.06.1991
(51) Int. Cl.: G03F 3/10

(54) **Vorrichtung zum Prüfen der Farbauszüge eines Mehrfarbendrucks**
Colourproof process for multicolour selections
Procédé pour l'épreuve des sélections de couleur en impression multicolore

(30) Priorität: 07.06.1990 DE 4018295
(43) Veröffentlichungstag der Anmeldung: 11.12.1991
(73) Patentinhaber: DU PONT DE NEMOURS (DEUTSCHLAND) GMBH, 61343 Bad Homburg v.d.H. (DE); E.I. DU PONT DE NEMOURS AND COMPANY, Wilmington Delaware 19898 (US)
(72) Erfinder: Konermann, Herbert, W-4540 Lengerich (DE); Sandner, Helmut Gustav, W-6054 Rodgau 3 (DE)
(74) Vertreter: Pistor, Wolfgang, Dr. Dipl.-Chem.

(56) Entgegenhaltungen:
- DE-C- 3 625 014
- FR-A- 2 103 839
- US-A- 4 638 372
- PATENT ABSTRACTS OF JAPAN vol. 010, no. 378 (M-546)17. Dezember 1986& JP - A - 61 171 370.
- PATENT ABSTRACTS OF JAPAN vol. 006, no. 228 (M-171)13. November 1982 & JP - A - 57 129 762.

## Beschreibung

Die Erfindung betrifft eine Vorrichtung zum Prüfen der Farbauszüge eines Mehrfarbendruckes, bestehend aus einem in einem Gestell gelagerten, aus voneinander abhebbaren Walzen gebildeten Preßwalzenpaar, durch dessen Walzenspalt im Betrieb ein Bildträger, der aus einer Trägerfolie mit einer belichteten fotoempfindlichen Schicht besteht, mit einer auf diesen aufgelegten Farbfolie, bestehend aus einer Farbträgerfolie mit einer Farbschicht, derart hindurchgeführt wird, daß Teile der Farbschicht an den klebrigen Stellen des Bildträgers haften bleiben.

Beim Mehrfarbendruck ist es zweckmäßig, vor dem eigentlichen Andruck die Qualität der Farbauszüge zu prüfen, ohne einen Probedruck durchführen zu müssen, damit eventuell noch erforderliche Korrekturen ausgeführt und Register und Passer kontrolliert werden können. Eine derartige Prüfung vollzieht sich in der Weise, daß von den einzelnen Vorlagen entsprechend gerasterte Farbauszüge erstellt und diese durch entsprechende Belichtung auf die fotoempfindliche Schicht eines Bildträgers kopiert werden. Bei einem bevorzugten Prüfdruckmaterial besteht die fotoempfindliche Schicht aus einem fotopolymerisierbaren Material, das zumindest an seiner Oberfläche klebrig ist und durch die Belichtung in der Weise polymerisiert wird, daß es an den belichteten Bereichen seine Klebrigkeit verliert. Auf den so belichteten Bildträger wird dann eine Farbträgerfolie in der Weise aufgedrückt, daß deren Farbschicht an den unbelichteten Stellen wegen deren Klebrigkeit haften bleibt. Die Farbe der Farbschicht entspricht dabei der Farbe des zu prüfenden Farbauszuges, so daß der Bildträger ein Positivbild des zu prüfenden Farbauszuges erhält. Auf den Bildträger wird dann eine zweite fotoempfindliche Schicht in Form eines Laminates aufgebracht und der Bildträger wird dann durch einen gerasterten Farbauszug einer zweiten Farbe der Vorlage belichtet. Auf diese zweite belichtete fotoempfindliche wird sodann eine Farbträgerfolie mit der zweiten Farbe aufgedrückt, so daß an den unbelichteten Stellen wiederum Teile der Farbfolie nach deren Abziehen haften bleiben und sich ein positives Zweifarbenbild der Vorlage ergibt. Entsprechend den vorgesehenen Druckfarben werden weitere fotoempfindliche Schichten aufgebracht, durch die weiteren gerasterten Farbauszüge belichtet und mit entsprechenden Farbaufträgen durch Aufdrücken der Farbschichten versehen, bis ein der Vorlage entsprechendes mehrfarbiges Bild entsteht. Prüfverfahren dieser Art und für die Prüfverfahren verwendbare fotoempfindliche Schichten sind aus der DE-PS 26 23 850, der EP-OS 243 933 und der US-PS 43 56 253 bekannt. Geeignete Farbträgerfolien sind in der DE-PS 36 25 014 und der DE-OS 37 06 528 beschrieben worden. In analoger Weise können auch fotoempfindliche Schichten verwendet werden, die erst bei Belichtung klebrig werden und aus der DE-PS 34 29 615 bekannt sind.

Ein besonderes Problem bei der Durchführung des Farbprüfverfahrens besteht darin, die Farbfolie auf die jeweils belichtete fotoempfindliche Schicht des Bildträgers aufzulegen und in der Weise aufzudrücken, daß nach dem Abziehen der Farbfolie das gewünschte Bild des Farbauszuges der Vorlage entsteht.

Sollen mit einer Vorrichtung der eingangs angegebenen Art beispielsweise die Farbauszüge eines Vierfarbendruckes geprüft werden, muß der Bildträger mit einer jeweils neu aufgetragenen belichteten fotoempfindlichen Schicht zusammen mit der entsprechenden Farbfolie viermal durch den Walzenspalt des Preßwalzenpaares hindurchgeschoben werden, was wegen der erforderlichen Manipulationen eine gewisse Geschicklichkeit erfordert und zeitaufwendig ist.

Aufgabe der Erfindung ist es, eine Vorrichtung der eingangs angegebenen Art zu schaffen, mit der sich einfach und schnell die Prüfung der Farbauszüge eines Mehrfarbendruckes durchführen läßt.

Erfindungsgemäß wird diese Aufgabe bei einer Vorrichtung der gattungsgemäßen Art dadurch gelöst, daß ein beweglicher Rahmen vorgesehen ist, in dem mehrere Paare von Rollenträgern für abund aufzuwickelnde Rollen gelagert sind, daß in einem Rollenträger jedes Paares eine Rolle mit einem Farbfolienband einspannbar und das Farbfolienband auf eine in dem anderen Rollenträger gehalterte Rolle aufwickelbar ist, so daß sich das Bahnstück des Farbfolienbandes zwischen den Rollen eines Paares von Rollenträgern zwischen den Preßwalzen des Preßwalzenpaares erstreckt, und daß bei voneinander abgehobenen Preßwalzen der Rahmen derart verschieblich ist, daß sich zwischen den Rollen der Paare von Rollenträgern befindlichen Bahnstücke des Farbfolienbandes zwischen die Preßwalzen bringen lassen.

Mit der erfindungsgemäßen Vorrichtung läßt sich die Farbprüfung einfach, schnell und genau durchführen, weil die Farbfolie mit der Farbe des jeweils zu prüfenden Farbauszugs in Form eines Farbbandes in der Vorrichtung aufgespannt gehalten ist, so daß nur bei zusammengefahrenen Preßwalzen des Preßwalzenpaares der vorbereitete Bildträger durch den Walzenspalt hindurchgeführt zu werden braucht.

Farbprüfverfahren mit Vorrichtungen, die jeweils mit einem Rollenträger für eine abzuwickelnde und eine aufzuwickelnde Rolle eines Farbfolienbandes versehen sind, wobei sich das Bahnstück des Farbfolienbandes zwischen den Rollen zwischen den Preßwalzen eines Preßwalzenpaares erstreckt, sind an sich aus einer offenkundigen Vorbenutzung bekannt. Da jedoch jede Vorrichtung nur eine abzuwickelnde und eine aufzuwickelnde Rolle mit einem Farbfolienband nur einer Farbe enthält, muß für jede zu prüfende Farbe eine besondere Vorrichtung vorgesehen werden, zur Prüfung eines Vierfarbendruckes also vier Vorrichtungen. Da jede dieser jeweils nur zur Prüfung eines Farbauszuges geeignete Vorrichtung zusätzlich auch ein Preßwalzenpaar mit auseinanderfahrbaren Preßwalzen enthalten muß, ist der maschinelle Aufwand zur Durchführung dieses bekannten Farbprüfverfahrens sehr aufwendig.

In weiterer Ausgestaltung der Erfindung ist vorgesehen, daß bei voneinander abgehobenen Preßwalzen der Rahmen derart verschieblich ist, daß sich wahlweise sämtliche zwischen den Rollen der Paare von Rollenträgern befindliche Bahnstücke der Farbfolienbänder zwischen die Preßwalzen gelangen.

Eine besonders einfache und präzise Handhabung ist gewährleistet, wenn beidseits des Walzenspaltes Zu- und Abführtische für den Bildträger angeordnet sind und der Walzenspalt in etwa in der Ebene der Tische liegt. Der Bildträger braucht dann nur auf den Zuführtisch bereitgelegt und in den Walzenspalt hineingeschoben zu werden.

Eine besonders einfache Halterung der Rollenträgerpaare in dem Rahmen ist dann gewährleistet, wenn dieser trommelförmig ausgebildet ist. Die Zu- und Abführungstische lassen sich dann etwa tangential zu dieser Trommel anordnen.

Wegen der hohen von den Preßwalzen aufzubringenden Drücke sind diese zweckmäßigerweise durch Paare von Stützwalzen abgestützt.

In weiterer Ausgestaltung der Erfindung ist vorgesehen, daß die untere Preßwalze gestellfest gelagert und mit einem Antrieb versehen ist. Die obere Preßwalze kann durch einen Spindeltrieb absenkbar sein.

In weiterer Ausgestaltung der Erfindung ist vorgesehen, daß der Träger für die obere Preßwalze abgefedert ist, wobei die Andrückkraft so eingestellt ist, daß eine gute Übertragung der Farbe von der Farbfolie auf den Bildträger erfolgt.

Zweckmäßigerweise steht der Rollenträger für die die Farbfolienbahn aufwickelnde Rolle durch einrückbare Zahnräder mit der unteren Preßwalze in getriebemäßiger Antriebsverbindung.

Der absenkbare Träger für die obere Preßwalze ist nach einer besonders vorteilhaften Ausgestaltung mit einer Abziehleiste für die Farbfolie versehen.

Ein Ausführungsbeispiel der Erfindung wird nachstehend anhand der Zeichnung näher erläutert. In dieser zeigt
- Fig. 1: eine Vorderansicht der Vorrichtung zur Prüfung der Farbauszüge eines Mehrfarbendruckes,
- Fig.2: einen Schnitt durch die Vorrichtung längs der Linie II-II und
- Fig. 3: eine vergrößerte perspektivische Schnittdarstellung eines Teils der Vorrichtung, die zeigt, daß bei abgesenkter Preßrolle 18 der Ansatz 20 in einen V-förmigen Ausschnitt 15 eingefahren ist.

Das Maschinengestell besteht aus den beiden Seitenwänden 1,2, die durch eine Traverse 3 fest miteinander verbunden sind. Auf die Traverse 3 sind Lagerböcke 4 und 5 aufgeschweißt, welche Stützrollen 6 aufnehmen. Diese beiden Stützrollen 6 unterstützen eine Druckrolle 7, die in den beiden Seitenwänden 1 und 2 antreibbar gelagert ist. Zum Zwecke ihres Antriebs ist ein Lagerzapfen 8 seitlich aus der Seitenwand 1 herausgeführt und trägt ein Kettenrad 9. Dieses Kettenrad steht über eine Kette 10 mit dem Kettenrad 11 eines Getriebemotors in Verbindung. Oberhalb des Lagerzapfens 13 der Druckrolle 7 ist eine Aufnahme 14 mit der Seitenwand verbunden, welche einen V-förmigen Ausschnitt 15 aufweist. Der Zweck dieser Aufnahme 15 wird später näher beschrieben.

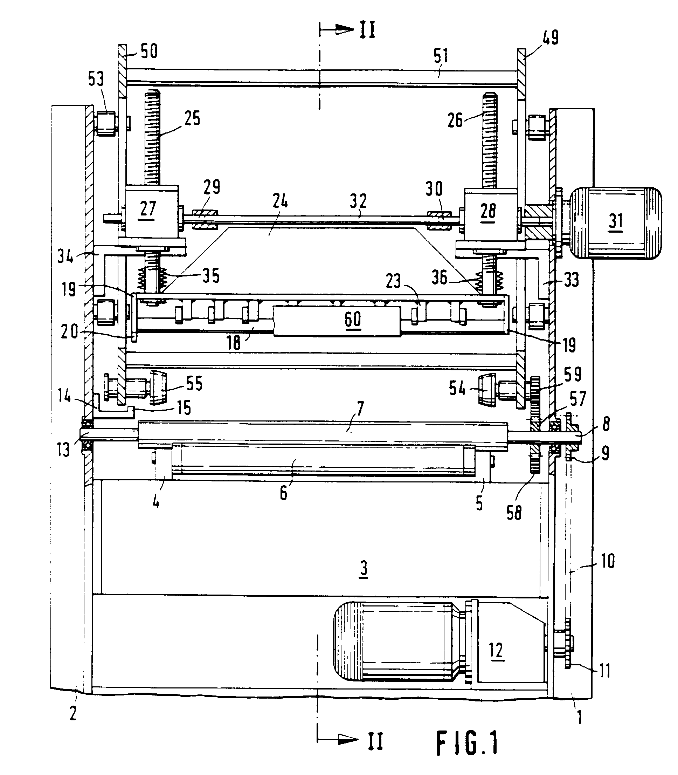

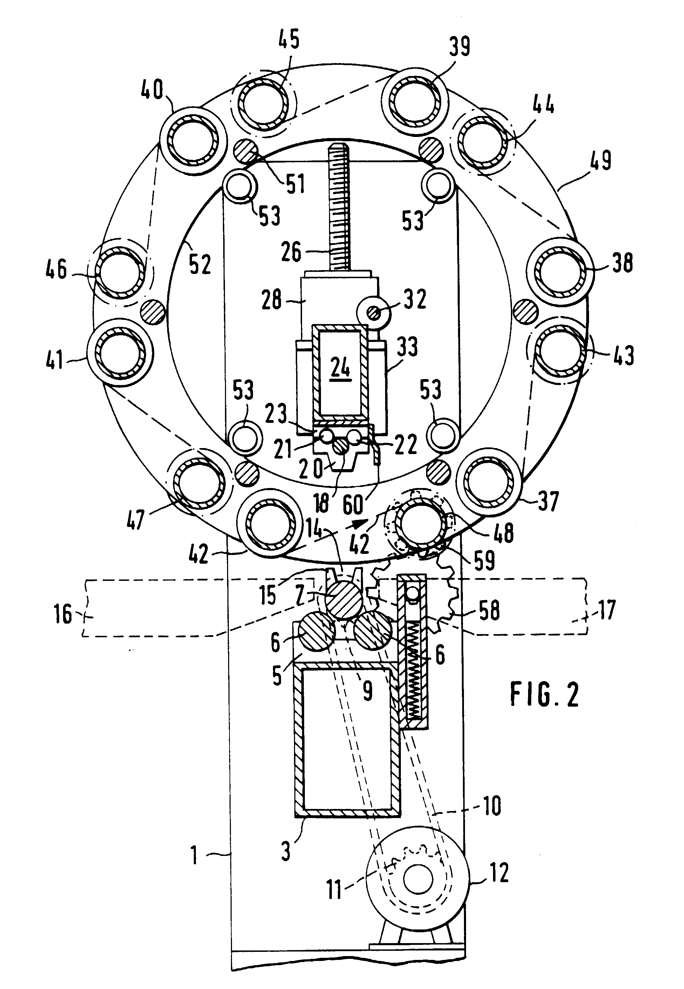

Wie aus der Figur 2 hervorgeht, sind der Druckrolle 7 ein Zuführtisch 16 sowie ein Abführtisch 17 zugeordnet, die zum Führen eines Bildträgers dienen. Der unteren Druckrolle 7 ist eine obere Preßrolle 18 zugeordnet, die in seitlichen Haltern 19 drehbar gelagert ist. Beide Halter 19 sind identisch ausgebildet und weisen einen nach unten spitz zulaufenden Ansatz 20 auf. Einer dieser beiden Ansätze 20, nämlich der in Figur 1 dargestellte linke, greift in den V-förmigen Ausschnitt 15 der Aufnahme 14 ein, sobald die Preßrolle nach unten bewegt wird und sich auf die Druckrolle 7 auflegt. Die Preßrolle 18 ist in den seitlichen Haltern 19 gelagert und wird von den Stützrollen 21 und 22 abgestützt, so daß eine Durchbiegung der Preßrolle 18 vermieden wird.

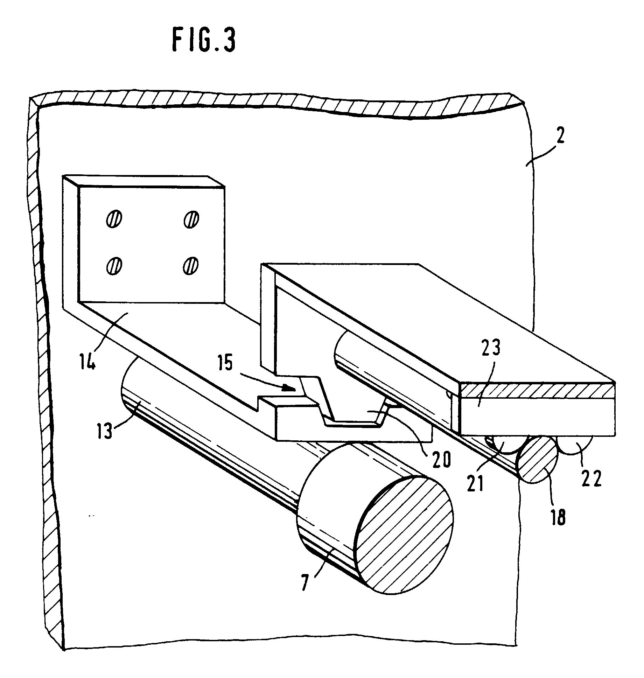

Aus Fig. 3 ist ersichtlich, daß bei abgesenkter Preßrolle 18 der Ansatz 20 in einen V-förmigen Ausschnitt 15 eingefahren ist, so daß die Preßrolle 18 während des Anpreßvorganges gegen ein seitliches Auswandern gesichert ist.

Insbesondere aus der Figur 1 geht weiterhin hervor, daß der Preßrolle 18 Gruppen von Stützrollen 21 und 22 zugeordnet sind, die über Lagerböcke 23 mit einem Hohlprofil 24 verbunden sind. Das Hohlprofil 24 ist an beiden Seiten abgeflacht und in diesen beiden Bereichen mit Spindeln 25 und 26 verbunden. Diese Spindeln sind drehgesichert in Getriebegehäusen 27 und 28 gelagert, wobei die Eingangswellen 29 und 30 jeweils mit einer nicht näher dargestellten Schnecke verbunden sind, die entsprechende Schneckenräder antreiben. Die Schneckenräder weisen eine zentrale Bohrung mit Innengewinde auf, welche in das Außengewinde der Spindeln 25 und 26 eingreifen. Sobald nun der Motor 31 betätigt wird, werden die Schneckenräder durch die mit den Eingangswellen 29 und 30 verbundenen Schnecken verdreht und dadurch die verdrehgesicherten Spindeln 25 und 26 in Achsrichtung bewegt. Die Eingangswellen 29 und 30 sind über eine Welle 32 miteinander verbunden. Die Getriebegehäuse 28 und 27 selbst sind auf Konsolen 33 und 34 aufgesetzt, die mit den Seitenwänden 1 und 2 fest verschraubt sind.

Aus der Figur 1 geht hervor, daß die Spindeln 25 und 26 an ihren dem Hohlprofil 24 zugewandten Enden abgesetzt sind, wobei die abgesetzten Teile von Druckfedern 35 und 36 umgriffen sind. Diese Druckfedern bewirken, daß sich bei der Abwärtsbewegung des Hohlprofils 24 die Preßrolle 18 weich auf die Druckrolle 7 aufsetzt und gegenüber dieser ausweichen kann, wenn Bild- und Farbträger durch den Walzenspalt geführt werden.

Die Farbträger sind in diesem Fall allerdings keine einzelnen Bögen, sie sind vielmehr zu Rollen 37 bis 42 aufgewickelt, die jeweils von zwei Aufnahmekonen 54 und 55 gehalten sind. Jeder dieser aufgerollten Farbbänder 37 bis 42 ist eine Leerhülse 43 bis 48 zugeordnet, auf die dann die einzelnen Farbbänder wieder aufgewickelt werden können. Sowohl die Farbbandrollen wie auch die Leerhülsen sind, wie schon erwähnt, durch jeweils 2 Konen 54,55 gehalten. Diese Konen lagern in zwei Scheiben 49,50, welche miteinander über Stangen 51 fest verbunden sind. Die Scheiben 49 und 50 sind als Ringscheiben ausgebildet und werden entlang ihrer inneren Lauffläche 52 über Führungsrollen 53 abgestützt, welche in den Seitengestellen 1 und 2 frei drehbar gelagert sind.

Wird nun beispielsweise über den Tisch 16 ein nicht dargestellter Bildträger zugeführt, wird die Preßrolle 18 über den Motor 31 nach unten gefahren und drückt dabei das zwischen der Farbbandrolle 42 und der Leerhülse 48 befindliche Farbband nach unten gegen die Druckrolle 7. Danach wird der Motor 12 eingeschaltet, der über die Kette 10 und das Kettenrad 9 die Druckrolle 7 antreibt, ebenso wie ein Ritzel 57, welches mit einem Übertragungsrad 58 kämmt. Dieses Übertragungsrad 58 ist nach unten ausweichbar gelagert und greift in ein Ritzel 59 ein, welches mit dem Zapfen des Aufnahmekonus 54 in Eingriff steht, so daß der Konus 54 beim Einschalten des Motors 12 angetrieben ist. Das Farbband 42 wälzt sich demzufolge während des Durchlaufs des nicht dargestellten Bildträgers auf diesem ab, so daß Farbe auf den Bildträger übertragen wird. Nach dem ersten Durchlauf des Bilträgers werden die Ringscheibe 49 und 50 im Gegenuhrzeigersinn soweit verdreht, daß das Ritzel des Aufnahmekonus für die Leerhülse 47 mit dem Übertragungsrad 58 in Eingriff steht. Der Bildträger kann danach, nach dem nochmaligen Absenken der Preßrolle 18, wiederum durch den Walzenspalt zwischen der Preßrolle 18 und der Druckrolle 7 geschoben werden. Bei diesem zweiten Durchgang wird dann eine zweite Farbe auf den Bildträger übertragen. In der dargestellten Vorrichtung sind insgesamt 6 Farben vorgesehen, so daß Klischees für einen Sechsfarbendruck überprüft werden können.

Damit sich nun aber das auf den Bildträger bei seinem Durchlauf durch den Walzenspalt aufgebügelte Farbband sauber vom Bildträger abziehen läßt, ist im Bereich der Röllchengruppe 22 mit den Lagerböcken 23 eine Abziehleiste 60 fest verbunden, durch die bewirkt wird, daß das auf einen Bildträger aufgebügelte Farbband beispielsweise von der Leerhülse 48 senkrecht nach oben abgezogen werden kann. Diese Art des Abziehens eines aufgebügelten Farbbandes von einem Bildträger ist besonders günstig.

## Patentansprüche

1. Vorrichtung zum Prüfen der Farbauszüge eines Mehrfarbendruckes,
bestehend aus einem in einem Gestell gelagerten, aus voneinander abhebbaren Walzen gebildeten Preßwalzenpaar, durch dessen Walzenspalt im Betrieb ein Bildträger, der aus einer Trägerfolie mit einer belichteten bildmäßig klebrige und nichtklebrige Bereiche aufweisenden fotoempfindlichen Schicht besteht, mit einer auf diesen aufgelegten Farbfolie, bestehend aus einer Farbträgerfolie mit einer Farbschicht, derart hindurchgeführt wird, daß Teile der Farbschicht an den klebrigen Stellen des Bildträgers haften bleiben,
**dadurch gekennzeichnet,**
daß ein beweglicher Rahmen (49,50) vorgesehen ist, in dem mehrere Paare von Rollenträgern (54,55) für ab- und aufzuwickelnde Rollen gelagert sind,
daß in einen Rollenträger jedes Paares eine Rolle mit einem Farbfolienband (37-42) einspannbar und das Farbfolienband auf eine in dem anderen Rollenträger gehalterte Rolle aufwickelbar ist , so daß sich das Bahnstück des Farbfolienbandes zwischen den Rollen eines Paares von Rollenträgern zwischen den Preßwalzen des Preßwalzenpaares erstreckt,
daß bei voneinander abgehobenen Preßwalzen (7,18) der Rahmen (49,50) derart verschieblich ist, daß sich zwischen den Rollen der Paare von Rollenträgern befindlichen Bahnstücke des Farbfolienbandes zwischen die Preßwalzen bringen lassen.

2. Vorrichtung nach Anspruch 1, dadurch gekennzeichnet, daß bei voneinander abgehobenen Preßwalzen (7,18) der Rahmen (49,50) derart verschieblich ist, daß wahlweise sämtliche sich zwischen den Rollen der Paare von Rollenträgern befindlichen Bahnstücke des Farbfolienbandes zwischen die Preßwalzen bringen lassen.

3. Vorrichtung nach Anspruch 1 oder 2, dadurch gekennzeichnet, daß beidseits des Walzenspaltes Zu- und Abführtische (16,17) angeordnet sind und der Walzenspalt in etwa in der Ebene der Tische liegt.

4. Vorrichtung nach einem der Ansprüche 1 bis 3, dadurch gekennzeichnet, daß der Rahmen (49,50,51) trommelförmig ausgebildet ist.

5. Vorrichtung nach einem der Ansprüche 1 bis 4, dadurch gekennzeichnet, daß die Preßwalzen (7,18) durch Stützwalzen (6,21,22) abgestützt sind.

6. Vorrichtung nach einem der Ansprüche 1 bis 5, dadurch gekennzeichnet, daß die untere Preßwalze (7) gestellfest gelagert und mit einem Antrieb (8,9,10,11,12) versehen ist.

7. Vorrichtung nach einem der Ansprüche 1 bis 6, dadurch gekennzeichnet, daß die obere Preßwalze (18) durch Spindeltriebe (25,26) absenkbar ist.

8. Vorrichtung nach einem der Ansprüche 1 bis 7, dadurch gekennzeichnet, daß der Träger (24) für die obere Preßwalze (18) abgefedert ist.

9. Vorrichtung nach einem der Ansprüche 1 bis 8, dadurch gekennzeichnet, daß der Rollenträger (54) für die die Farbfolienbahn aufwickelnde Rolle durch einrückbare Zahnräder (58,59) mit der unteren Preßwalze (7) zur Vermeidung einer Faltenbildung in getriebemäßiger Antriebsverbindung steht.

10. Vorrichtung nach einem der Ansprüche 1 bis 9, dadurch gekennzeichnet, daß der absenkbare Träger für die obere Preßwalze (18) mit einer Abziehleiste (60) oder einer Abziehwalze für die Farbfolie versehen ist.

## Claims

1. Apparatus for testing the color separations of a multicolor print,
comprising a pair of press rollers being mounted in a frame and constituted by rollers which can be lifted off each other, through the roller gap of which during operation an image-bearing element, consisting of a support foil with an exposed, photosensitive layer with tacky and nontacky areas according to the image, with a color foil, consisting of a color-bearing foil with a color layer, being placed on this element, is fed such that portions of the color layer adhere to the tacky areas of the image-bearing element,
wherein
a movable frame (49, 50) is provided in which a plurality of pairs of roll bearings (54, 55) for rolls to be unwound and wound up are mounted,
a roll bearing for each pair of rolls allows a roll of a color foil (37-42) to be loaded and the color foil can be wound up on a roll carried in the other roll bearing, and wherein the course of the web section of the color foil between the rolls of a pair of roll bearings runs in between the press rollers of the pair of press rollers, wherein for press rollers (7, 18) being lifted off each other the frame (49, 50) is shiftable such that web sections of the color foil webs, extending between the rolls of the pairs of roll bearings, can be brought between the press rollers.

2. Apparatus according to claim 1, wherein for press rollers (7, 18) being lifted off each other the frame (49, 50) is shiftable such that alternatively all web sections of the color foil webs, extending between the rolls of the pairs of roll bearings, can be brought between the press rollers.

3. Apparatus according to claim 1 or 2, wherein on both sides of the roller gap input tables and output tables (16, 17) are arranged and the roller gap lies approximately in the plane of the tables.

4. Apparatus according to to any one of claims 1 through 3, wherein the frame (49, 50, 51) is designed to have the form of a drum.

5. Apparatus according to to any one of claims 1 through 4, wherein the press rollers (7, 18) are supported by support rollers (6, 21, 22).

6. Apparatus according to to any one of claims 1 through 5, wherein the lower press roller (7) is fixed in position and provided with a drive (8, 9, 10, 11, 12).

7. Apparatus according to to any one of claims 1 through 6, wherein the upper press roller (18) can be lowred by spindle drives (25, 26).

8. Apparatus according to to any one of claims 1 through 7, wherein the bearing (24) for the upper press roller (18) is spring-loaded.

9. Apparatus according to to any one of claims 1 through 8, wherein the roll bearing (54) for the roll to wind up the color foil web is drivingly connected with the lower press roller (7) by engagable tooth wheels (58, 59) for avoiding a formation of folds.

10. Apparatus according to to any one of claims 1 through 9, wherein the lowerable bearing for the upper press roller (18) is provided with a peeling-off ledge (60) or a peeling-off roller for the color foil.

## Revendications

1. Dispositif pour réaliser un contrôle des sélections de couleur en impression polychrome se composant d'une paire de cylindres comprimeurs montés dans un châssis et constituée d'une paire de cylindres susceptibles d'être écartés l'un de l'autre et dans l'emprise desquels on fait passer, en service, un élément support d'image composé d'un film support portant une couche photosensible exposée selon une image et présentant des régions adhérentes et non adhérentes, avec un film de couleur, consistant en un film support de couleur portant une couche de couleur placé sur ledit élément, de façon que des parties de la couche de couleur adhérent aux régions adhérentes de l'élément support d'image,
caractérisé en ce que
il comporte un cadre mobile (49, 50) dans lequel sont fixées plusieurs paires de supports (54. 55) de bobines pour des bobines à débobiner et embobiner; en ce que, dans l'un des supports de chaque paire, puisse être tendue une bobine de pellicule couleur (37, 42) et la pellicule couleur puisse être embobinée sur une bobine montée sur l'autre support de bobine, de façon que le lé de la bande de pellicule couleur s'étend entre les bobines d'une paire de supports de bobines entre les cylindres comprimeurs et en ce que, lorsque les cylindres comprimeurs (7, 18) sont écartés l'un de l'autre, le cadre (49, 50) est mobile de façon telle que le lé se trouvant entre les bobines d'une paire de supports de bobine puisse être amené entre les cylindres comprimeurs.

2. Dispositif selon la revendication 1, caractérisé en ce que, lorsque les cylindres comprimeurs (7, 18) sont écartés l'un par rapport à l'autre, le cadre (49, 50) est susceptible d'être déplacé de telle façon qu'éventuellement, tous les lés du film de couleur se trouvant entre les bobines de la paire de supports de bobine, puissent être amenés entre les cylindres comprimeurs.

3. Dispositif selon la revendication 1 ou 2, caractérisé en cc que de part et d'autre de l'emprise des cylindres, sont disposées des tables de guidage d'entrée et de sortie (16, 17) et en ce que l'emprise des cylindres est situé sensiblement dans le plan des tables.

4. Dispositif selon l'une quelconque des revendications 1 à 3, caractérisé en ce que le cadre (49, 50. 51) est réalisé en forme de tambour.

5. Dispositif selon l'une quelconque des revendications 1 à 4 caractérisé en cc que les cylindres comprimeurs (7, 18) sont supportés par des cylindres d'appui (6, 21, 22).

6. Dispositif selon l'une quelconque des revendications 1 à 5, caractérisé en ce que le cylindre comprimeur inférieur (7) est monté en position fixe par rapport au châssis et est muni d'un moyen d'entraînement (8, 9, 10, 11, 12).

7. Dispositif selon l'une des revendications 1 à 6, caractérisé en ce que le cylindre comprimeur supérieur (18) est susceptible d'être abaissé par un mécanisme à broche (25, 26).

8. Dispositif selon l'une quelconque des revendications 1 à 7, caractérisé en ce que le support (24) du cylindre comprimeur supérieur (18) est muni d'une suspension élastique.

9. Dispositif selon l'une quelconque des revendications 1 à 8, caractérisé en ce que le support de bobine (54) de la bobine de bobinage du lé de film de couleur est engagé en liaison d'entraînement avec le cylindre comprimeur inférieur (7) par l'intermédiaire de roues d'engrenage (58, 59) susceptibles de venir en prise, afin d'éviter la formation de faux plis.

10. Dispositif selon l'une quelconque des revendications 1 à 9, caractérisé en ce que le support susceptible d'être abaissé du cylindre comprimeur supérieur (18) est muni d'une barrette (60) ou d'un cylindre de pelage ou d'arrachement pour le film de couleur.
